Europäisches Patentamt

European Patent Office

Office européen des brevets

(11) Publication number: **0 382 987**
**A1**

## (12) EUROPEAN PATENT APPLICATION

(21) Application number: **89400391.2**

(22) Date of filing: **13.02.89**

(51) Int. Cl.5: **C23C 16/44, C23C 16/52**

(43) Date of publication of application:
**22.08.90 Bulletin 90/34**

(84) Designated Contracting States:
**FR**

(71) Applicant: **L'AIR LIQUIDE, SOCIETE ANONYME POUR L'ETUDE ET L'EXPLOITATION DES PROCEDES GEORGES CLAUDE**
**75, Quai d'Orsay**
**F-75321 Paris Cédex 07(FR)**

(72) Inventor: **Hirase, Ikuo**
**5-9-9 Tokodai Toyosato-machi**
**Tsucuba-Gun 300-26(JP)**

(74) Representative: **Vesin, Jacques et al**
**L'AIR LIQUIDE, SOCIETE ANONYME POUR L'ETUDE ET L'EXPLOITATION DES PROCEDES GEORGES CLAUDE 75, quai d'Orsay**
**F-75321 Paris Cédex 07(FR)**

(54) **Gas supplying apparatus.**

(57) An apparatus for supplying gases of those substance which are liquid or solid at room temperature comprising a gas supplying apparatus comprising a container (12) for receiving a substance (11) which is liquid or solid, a means for heating the container, an inlet pipe (13) connected to the container (12) in order to introduce a carrier gas into the container, a carrier gas line (15) for supplying the carrier gas to the inlet pipe (13), an outlet pipe (14) connected to the container (12) in order to introduce the vaporized gas of the substance (11) out of the container (12), and a substance gas line (40) connected to the outlet pipe (14), wherein the substance (11) received in the container (12) is vaporized by heating and the vaporized gas thus generated is associated with the carrier gas and supplied through the substance gas line (40), characterized in that a vacuum oven (30) in which the container (12), the inlet pipe (13), the outlet pipe (14), and a part of the carrier gas line (15) and a part of the substance gas line (40) are housed therein is used as the means for heating the container (12) and that said vacuum oven (30) is purged with a chemically inactive gas to fill it with inert atmosphere.

F I G. 2

EP 0 382 987 A1

The present invention relates to an apparatus for supplying gases of those substances which are liquid or solid at room temperature and more particularly, it relates to an apparatus for supplying gases of those substances which are dangerous and hard to vaporize.

Substances which are liquid or solid at room temperature and hard to vaporize because of their low vapor pressure are used as material gas for chemical vapor deposition (CVD) in the semiconductor industry. These substances include inorganic halides such as $WF_6$, $MoF_6$ and $TiC\ell_4$, organometalic compounds such as $A\ell(C_2H_5)_3$, $A\ell(CH_3)_3$, $A\ell(i-C_4H_9)_3$, $Zn(C_2H_5)_2$, $Cd(CH_3)_2$ and $In(C_2H_5)_3$ and inorganic hydride such as $Si_3H_8$. They are harmful to human being and it is difficult to treat them because they are likely to become dangerous or inflammable, reacting with $O_2$ or $H_2O$ in the air.

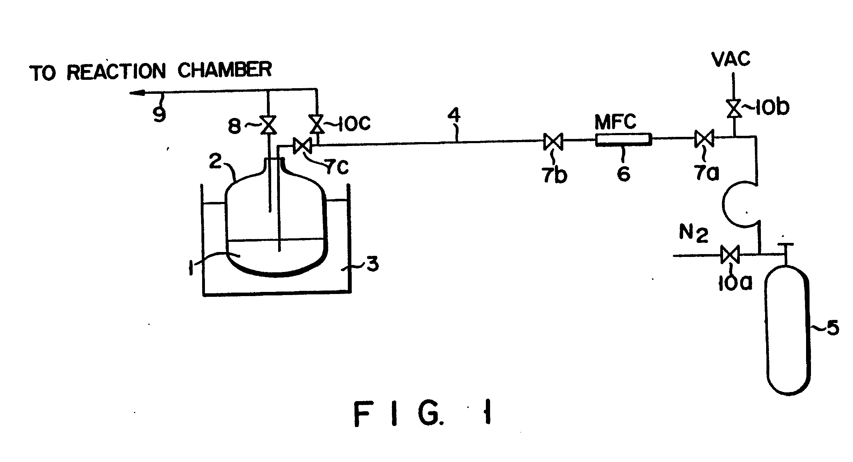

The apparatus shown in Fig. 1 is used to supply gases of the above-mentioned substances. Liquid substance 1 which is the raw material is received in container 2. Container 2 is heated in a hot bath to accelerate vaporization of liquid substance 1. Container 2 is connected to carrier gas cylinder 5 through line 4. The carrier gas is selected among $H_2$ and inert gases such as Ar and Ne. When $H_2$ is used as another material gas for the CVD, it is preferable to use $H_2$ as the carrier gas. The carrier gas is introduced into container 2, passing through mass flow controller 6 and valves 7a - 7c on line 4, and bubbled in liquid substance 1 which is vaporized by this bubbling of the carrier gas. The substance gas formed by vaporization of liquid 1 is associated with the carrier gas and supplied to a reaction chamber, passing through valve 8 and line 9. The amount of substance gas supplied is indirectly calculated from the vapor pressure (or partial pressure) of liquid substance 1. Valves 10a - 10c are intended to purge the pipe line with the carrier gas or $N_2$.

When liquid substance 1 is easily vaporized only by heat supply from hot bath 3, the carrier gas may be passed through container 2 and it is not needed to bubble the carrier gas into liquid substance 1. The same can be said about the case where substance 1 is solid and sublimited easily.

The conventional apparatus has the following drawbacks.

If the container or pipe line has a leak, harmful gas will be escaped into the air to contaminate working circumstances. As already described above, the above-mentioned gases react with $O_2$ and $H_2O$ in the air and this is exothermic reaction. When pressure in the container and pipe line is lower than atmospheric pressure, air enters into the container and pipe line to create extremely dangerous situation such as combustion and explosion.

Even when air entering into the container and pipe line through the leak is extremely little and the above-mentioned dangerous situation is not caused, the CVD is seriously influenced. More specifically, substance 1 sometimes reacts with air entering into the container and pipe line through the leak to generate particles. When these particles are supplied to the reaction chamber for the CVD, thin film formed by the CVD is caused to have defects and manufacturing efficiency is thus extremely lowered.

The amount of gas supplied is indirectly calculated from the vapor pressure of substance 1 which is liquid or solid. Therefore, the amount of gas supplied cannot be precisely controlled and it is difficult to keep the CVD reaction stable.

The present invention is intended to eliminate the above-mentioned drawbacks.

An object of the present invention is therefore to provide an apparatus for supplying gases of those substances which are liquid or solid at room temperature and having high safety.

Another object of the present invention is to provide an apparatus for supplying gases of those substances which are liquid or solid at room temperature and capable of precisely controlling the amount of gas supplied.

The first object of the present invention can be achieved by a gas supplying apparatus comprising a container for receiving a substance which is liquid or solid, a means for heating the container, an inlet pipe connected to the container in order to introduce a carrier gas into the container, a carrier gas line for supplying the carrier gas to the inlet pipe, an outlet pipe connected to the container in order to introduce the vaporized gas of the substance out of the container, and a substance gas line connected to the outlet pipe, wherein the substance received in the container is vaporized by heating and the vaporized gas thus generated is associated with the carrier gas and supplied through the substance gas line, characterized in that a vacuum oven in which the container, the inlet pipe, the outlet pipe, and a part of the carrier gas line and a part of the substance gas line are housed therein is used as the means for heating the container and that said vacuum oven is purged by a chemically inactive gas to fill it with insert atmosphere.

It is preferable that a detector is attached to the apparatus to detect the concentration of oxygen in the vacuum oven and that vacuum aspiration and purge of the vacuum oven with chemically inactive gas are automatically conducted when an oxygen concentration higher than a predetermined value is detected.

It is also preferable that an exterior door is attached to the entrance of the vacuum oven and that an O-ring is arranged along the rim of the exterior door to seal the vacuum oven when pressure in the vacuum oven is reduced.

When the vapor pressure of the substance which is liquid or solid at room temperature is relatively high and the substance can be vaporized only by heat, the means for supplying carrier gas is not needed.

The container in which the liquid substance to be vaporized is received and main portions of the pipes are held in chemically inert gas in the case of the gas supplying apparatus of the present invention. Even when any leak is caused in the container and main portions of the pipes, therefore, such trouble as seen in the conventional apparatus can be avoided.

The second object of the present invention can be achieved by a gas supplying apparatus comprising a container for receiving a substance which is liquid or solid at room temperature, a means for heating the container, an inlet pipe connected to the container in order to introduce a carrier gas into the container, a carrier gas line for supplying the carrier gas to the inlet pipe, an outlet pipe connected to the container in order to introduce the vaporized gas of the substance out of the container, and a substance gas line connected to the outlet pipe, wherein the substance received in the container is vaporized by heating and the vaporized gas thus generated is associated with the carrier gas and supplied through the substance gas line, characterized in that a mass flow controller is arranged on the carrier gas line in order to measure and adjust the flow rate of the carrier gas, that a mass flow meter is arranged on the substance gas line in order to measure the flow rate of the total gas flowing through the substance gas line, and that a control unit is provided in order to calculate the amount Q of the vaporized gas supplied through the substance gas line on the basis of a following equation, and in order to control the mass flow controller to adjust the flow rate of the carrier gas for making the Q a predetermined value.

$$Q = (X - Y)$$

wherein X denotes a value measured by the mass flow meter and Y denotes a value measured by the mass flow controller.

This invention can be more fully understood from the following detailed description when taken in conjunction with the accompanying drawings, in which:

Fig. 1 shows the conventional gas supplying apparatus; and

Fig. 2 shows an example of the gas supplying apparatus according to the present invention.

In Fig. 1, numeral 11 represents a liquid sub-stance such as $SiH_4$ and $WF_6$ and this substance is received in container 12. Container 12 is provided with an inlet pipe 13 for introducing carrier gas and an outlet pipe 14 for introducing vaporized substance out of container 12. The foremost end of inlet pipe 13 is kept in liquid substance 11. Inlet pipe 13 is connected to $H_2$ cylinder 16 through carrier gas line 15. Namely, $H_2$ is used as the carrier gas in this example. Valves 18a - 18d are arranged on the carrier gas line 15 and mass flow controller 17 is located between valves 18a and 18b. Mass flow controller 17 measures and controls the flow rate of the carrier gas supplied through line 15. Purging valves 19a and 19b are arranged on carrier gas line 15 and the inside of the line is purged by $N_2$.

Outlet pipe 14 is connected to substance gas line 40 which is communicated with a reaction chamber in the CVD apparatus. Valves 21a - 21c are arranged on line 40. Mass flow meter 20 is located between valves 21b and 21c to measure the flow rate of gas (vapor of substance 11 + carrier gas) flowing through substance gas line 40. Valves 22a - 22c are arranged to purge inside of substance gas line 16. Ar is used to purge this line 40.

Mass flow meter 20 and mass flow controller 17 are connected to control unit 23, which calculates the flow rate Q of substance gas (vapor of liquid substance 11) supplied to the CVD apparatus, using an equation Q = (X - Y) wherein Q represents the flow rate of the substance gas, X the flow rate of (the substance gas + carrier gas) measured by mass flow meter 20, and Y the flow rate of (carrier gas) measured by mass flow controller 17. Control unit 23 adjusts the opening of mass flow controller 17 responsive to and depending on value Q. The flow rate of the carrier gas can be thus adjusted in order to obtain a predetermined value Q (or amount of supplied substance gas).

In the case of this gas supplying apparatus, container 12 in which substance 11 is received, carrier gas line 15 located on the container side of valve 18b, and substance gas line 16 including at least up to valve 21c are housed in vacuum oven 30. Vacuum oven 30 is heated to a predetermined temperature by a heater (not shown) and connected to vacuum pump 31 through exhaust line 32, which is provided with valve 33, to reduce its pressure to a desired value. Pressure gauge 39 is attached to vacuum oven 30 to measure the pressure in the oven. Purging valve 34 and detector 35 for detecting the oxygen concentration are arranged on exhaust line 32. For precise detection, it is more preferable to arrange oxygen detector 35 in vacuum oven 30. Vacuum oven is also connected to an $N_2$ supply source through valve 36. Exterior door 38 is attached to the entrance of vacuum oven 30 through O-ring 37.

A case where gas of WF₆, for example, is supplied by this gas supplying apparatus will be described. Liquid substance 11 or WF₆ is received in container 12 and necessary purging is applied to the pipes. Valve 35 is opened to reduce pressure in vacuum oven 30. Valve 36 is then opened to introduce N₂ into vacuum oven 30. Pressure in vacuum oven 30 is kept lower than the atmospheric pressure, preferably 700 Torr or less, more preferably 500 Torr or less. The inside of vacuum oven 30 is thus purged quickly. This purging is finished for several minutes. The reason why this quick and complete purging can be conducted is that vacuum aspiration by pump 31 is added. It usually takes several hours to carry out complete purging under the common condition which includes no vacuum aspiration. As vacuum oven 30 is reduced in pressure, door 36 is closely pressed against O-ring 37 by the atmospheric pressure, thereby keeping vacuum oven 39 sealed. Vacuum oven 30 is heated by the heater (not shown) and container 12 and those portions of the pipes which are housed in vacuum oven 30 are thus controlled to have a predetermined temperature.

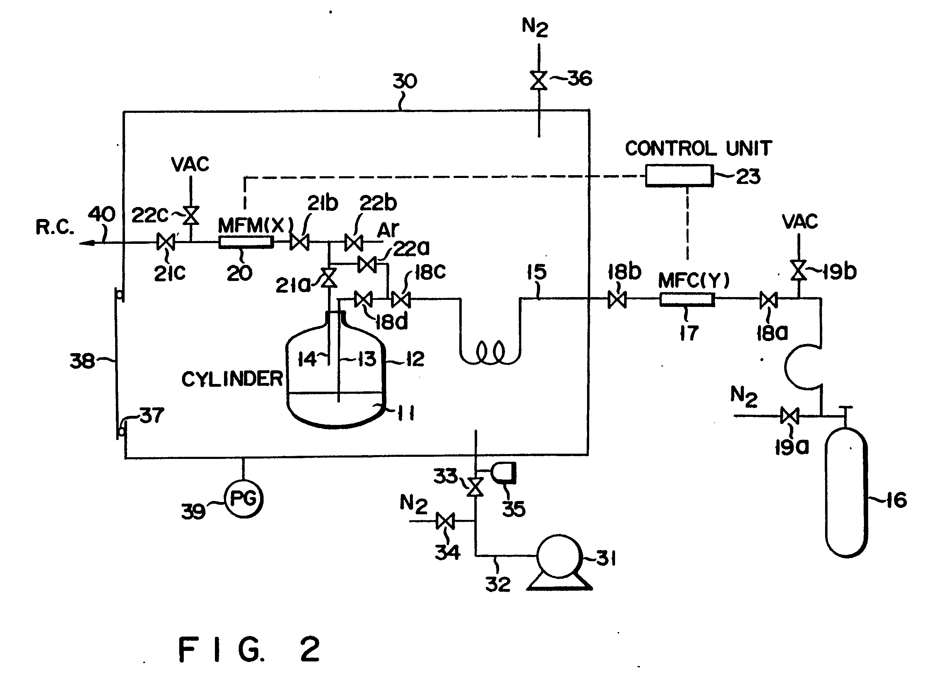

When H₂ is supplied as the carrier gas from H₂ cylinder 16 under the above-described condition, substance gas generated by vaporization of liquid 11 is associated with H₂ and supplied to the CVD apparatus, passing through line 40, in the form of its being associated with H₂. When that portion of carrier gas line 15 which is housed in vacuum oven 30 is made sufficiently long as shown in Fig. 2, the carrier gas can be sufficiently heated and blown into liquid substance 11. A high vaporizing efficiency can be thus obtained. When the oxygen concentration in vacuum oven 30 is made high by leak through entrance 38, for example, or some other causes while the gas is being supplied to the CVD apparatus, O₂ detector 35 detects this increase in the oxygen concentration. Valve 36 is opened responsive to detection signal applied from detector 35 and vacuum oven 30 is again purged. As the result, vacuum oven 30 is always filled with N₂ which is chemically inactive. Even when any leak is caused in container 12 and pipes housed in vacuum oven 30, therefore, O₂ and H₂ will never enter into vacuum oven 30 through the leak. This prevents the gas supplying apparatus from being brought under dangerous state such as combustion and explosion and substance gas of good quality is supplied to the CVD apparatus.

According to the gas supplying apparatus as described above, the flow rate of substance gas supplied to the CVD apparatus can be precisely controlled by a combination of mass flow controller 17, mass flow meter 20 and control unit 23. Thin film depositing reaction is thus stably conducted in the CVD apparatus, thereby enabling uniform thin film of high quality to be formed.

It is not necessarily required in this gas supplying apparatus that the foremost end portion of inlet pipe 13 is kept in liquid substance 11. Substance 11 may be solid like TiCl₄ under normal temperature.

When the vapor pressure of substance 11 is relatively high and it can be sufficiently gasified only by heating, the carrier gas supplying system is not needed at all. Mass flow meter 20 is replaced by the mass flow controller in this case.

Even when vacuum oven 30 and its accessories are not provided in this gas supplying apparatus, the flow rate of substance gas supplied to the CVD apparatus can be precisely controlled by the combination of mass flow controller 17, mass flow meter 20 and control unit 23.

## Claims

1. A gas supplying apparatus comprising a container (12) for receiving a substance (11) which is liquid or solid, a means for heating the container, an inlet pipe (13) connected to the container (12) in order to introduce a carrier gas into the container, a carrier gas line (15) for supplying the carrier gas to the inlet pipe (13), an outlet pipe (14) connected to the container (12) in order to introduce the vaporized gas of the substance (11) out of the container (12), and a substance gas line (40) connected to the outlet pipe (14), wherein the substance (11) received in the container (12) is vaporized by heating and the vaporized gas thus generated is associated with the carrier gas and supplied through the substance gas line (40), characterized in that a vacuum oven (30) in which the container (12), the inlet pipe (13), the outlet pipe (14), and a part of the carrier gas line (15) and a part of the substance gas line (40) are housed therein is used as the means for heating the container (12) and that said vacuum oven (30) is purged with a chemically inactive gas to fill it with inert atmosphere.

2. The gas supplying apparatus according to claim 1, characterized in that a mass flow controller (17) is arranged on the carrier gas line (15) in order to measure and adjust the flow rate of the carrier gas, that a mass flow meter (20) is arranged on the substance gas line (40) in order to measure the flow rate of the total gas flowing through the substance gas line (40), and that a control unit (33) is provided in order to calculate the amount Q of the vaporized gas supplied through the substance gas line (40) on the basis of a following equation, and in order to control the mass flow controller (17) to adjust the flow rate of the carrier gas for keeping the amount Q at a predetermined value.

$Q = (X - Y)$

wherein X denotes a value measured by the mass flow meter (20) and Y denotes a value measured by the mass flow controller (17).

3. A gas supplying apparatus comprising a container (12) for receiving a substance (11) which is liquid or solid, a means for heating the container (12), an outlet pipe (14) connected to the container (12) in order to introduce the vaporized gas of the substance (11) out of the container (12), and a substance gas line (40) connected to the outlet pipe (14), wherein the substance (11) received in the container (12) is vaporized by heating and the vaporized gas thus generated is supplied through the substance gas line (40), characterized in that a vacuum oven (30) in which the container (12), the outlet pipe (14), and a part of the substance gas line (40) are housed therein is used as the means for heating the container (12) and that said vacuum oven (30) is purged with a chemically inactive gas to fill it with the inert atmosphere.

4. The gas supplying apparatus according to any one of claims 1 to 3 characterized in that a detector (35) is provided to detect the oxygen concentration in the vacuum oven (30) and that when a oxygen concentration higher than a predetermined value is detected, vacuum aspiration and purging with the chemically inactive gas are automatically conducted.

5. The gas supplying apparatus according to any one of claims 1 to 4 characterized in that said oxygen detector (35) is arranged in the vacuum oven (30).

6. The gas supplying apparatus according to any one of claims 1 to 5 characterized in that an exterior door (38) is attached to the entrance of said vacuum oven (30) through an O-ring (37).

7. A gas supplying apparatus comprising a container (12) for receiving a substance (11) which is liquid or solid, a means for heating the container (12), an inlet pipe (13) connected to the container (12) in order to introduce a carrier gas into the container (12), a carrier gas line for supplying the carrier gas to the inlet pipe (13), an outlet pipe (14) connected to the container (12) in order to introduce the vaporized gas of the substance (11) out of the container (12), and a substance gas line (40) connected to the outlet pipe (14), wherein the substrate (11) received in the container (12) is vaporized by heating and the vaporized gas thus generated is associated with the carrier gas and supplied through the substance gas line (40), characterized in that a mass flow controller (17) is arranged on the carrier gas line (15) in order to measure and adjust the flow rate of the carrier gas, that a mass flow meter (20) is arranged on the substance gas line (40) in order to measure the flow rate of the total gas flowing through the substance gas line (40), and that a control unit (23) is provided in order to calculate the amount Q of the vaporized gas supplied through the substance gas line (40) on the basis of a following equation, and in order to control the mass flow controller (17) to adjust the flow rate of the carrier gas for keeping the amount Q at a predetermined value.

$Q = (X - Y)$

wherein X denotes a value measured by the mass flow meter (20) and Y denotes a value measured by the mass flow controller (17).

TO REACTION CHAMBER

VAC

MFC

N₂

F I G. 1

EP 0 382 987 A1

F I G. 2

EP 0 382 987 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN, vol. 9, no. 41 (C-267)[1764], 21st February 1985; & JP-A-59 185 772 (NIHON TAIRAN K.K.) 22-10-1984 * Abstract * --- | 1-3,7 | C 23 C 16/44 <br> C 23 C 16/52 |
| A | WO-A-8 701 614 (J.C. SCHUMACHER CO.) * Figure 1; page 5, line 26 - page 6, line 12 * --- | 1,7 | |
| A | EP-A-0 286 158 (SIEMENS) * Claim 1 * ----- | 2,3,7 | |

TECHNICAL FIELDS SEARCHED (Int. Cl.5)

C 23 C

The present search report has been drawn up for all claims

| Place of search | Date of completion of the search | Examiner |
|---|---|---|
| THE HAGUE | 13-10-1989 | PATTERSON A.M. |